# EUROPEAN PATENT APPLICATION

(11) **EP 4 786 052 A1**
(43) Date of publication of application: **05.08.2026**
(21) Application number: 25155101.6
(22) Date of filing: 30.01.2025
(51) Int. Cl.: B01L 3/02, B01L 3/00, B81B 3/00

(54) **FLUIDIC DEVICES AND FABRICATION OF FLUIDIC DEVICES**

(71) Applicant: 3C Project Technologies Limited, Greystones 281603 (IE)
(72) Inventor: MCAVOY, Gregory John, Greystones, 281603 (IE); COULL, Richard, Greystones, 281603 (IE)
(74) Representative: Hindles Limited

(57) **Abstract**

There is provided a method for fabricating a fluidic device. The method comprises providing one or more MEMS actuators, deposited in one or more steps, on a substrate. The one or more MEMS actuators comprise a photosensitive layer. The method further comprises forming one or more channels through at least a portion of the photosensitive layer. The fluidic device is configured to move fluid through the one or more channels using the one or more MEMS actuators. The step of forming the one or more channels comprises directing electromagnetic radiation on at least part of the photosensitive layer.

## Description

### Field of the invention

The present invention relates to methods of making fluidic devices and fluidic devices.

### Background to the invention

Fluidic devices are useful for a range of applications which involve delivery and/or extraction of fluids. For example, they are also known for use in medical, wet laboratory techniques and printing applications. For many applications within these technical fields, there is a need for fluidic devices which can deliver and extract very small quantities of fluid - e.g., droplets.

Microelectromechanical system (MEMS) techniques can be used to fabricate miniaturised devices having electrical and mechanical components. It is known to provide fluidic devices having microelectromechanical system (MEMS) components. However, the manufacturing of these devices can be challenging. It particular, it can be challenging to manufacture effective devices in a convenient and cost-effective way.

It is in this context that the present invention has been devised.

### Summary of the invention

In accordance with an aspect of the present invention, there is provided a method for fabricating a fluidic device, the method comprising:
providing one or more MEMS actuators, deposited in one or more steps, on a substrate, the one or more MEMS actuators comprising a photosensitive layer; and
forming one or more channels through at least a portion of the photosensitive layer,
wherein the fluidic device is configured to move fluid through the one or more channels using the one or more MEMS actuators, and
wherein the step of forming the one or more channels comprises directing electromagnetic radiation on at least part of the photosensitive layer.

Conventional methods for forming channels through MEMS actuators typically involve physical etching (e.g., dry etching methods such as deep reactive-ion etching (DRIE)). A photosensitive layer comprises a material that is capable of changing one or more structural properties (e.g., chemical and/or physical properties) in response to absorption of electromagnetic radiation (e.g., visible light). The inventors have realised that channels with more controllable features (compared to the conventional physical etching methods) can be provided using the method described hereinabove. For example, more uniform channels can be provided. In particular, the use of photosensitive material and electromagnetic radiation is a cleaner process compared to conventional methods. Conventional etching processes result in redeposition of etched material which can cause the channel to become roughened and/or contaminated.

Further, this method is also compatible with and straightforward to implement in existing foundry workflows.

The use of electromagnetic radiation rather than physical etching methods such as DRIE also means that there is less variability in the structures formed over the lateral extent of the device (i.e., less variability between structures at the centre of the substrate compared to the edge of the substrate).

Physical etching is also time and energy consuming. The time and energy required can be particularly burdensome for fluidic devices having multiple layers because the height of the portion through which the channel is formed is increased. The inventors have realised that by using photosensitive material and electromagnetic radiation to form the one or more channels that the fabrication is more energy and time efficient (particularly for devices with high aspect ratios).

It will be understood that microelectromechanical systems (MEMS) components are small devices that combine both mechanical and electrical components. In other words, the devices have parts configured to move and parts configured to send and/or receive electrical signals. The size of each individual MEMS component is typically less than 1 millimetre, such as less than 100 microns.

It may be that the photosensitive layer comprises a photoresist material. It may be that the photosensitive layer comprises a positive photoresist material. It may be that the photosensitive layer comprises a negative photoresist material (e.g., SU-8). It will be understood that a positive photoresist material is a material that is removable following exposure to electromagnetic radiation (e.g., removable by washing with a photodeveloper solution). It will be further understood that a negative photoresist material is a material that becomes harder to remove after exposure to electromagnetic radiation (e.g., the portions which have not been exposed to electromagnetic radiation are dissolvable using a photodeveloper solution, whereas the exposed portions are not dissolvable using the same photodeveloper solution).

It may be that the photosensitive layer comprises SU-8. The inventors have realised that SU-8 in particular has high chemical resistance to typical fluids of relevance, and good adhesion to the underlying layers of the device. This means that undesired fluid ingress and interfacial delamination is avoided.

Typically, the step of forming the one or more channels comprises selecting an intensity of electromagnetic radiation that will cause a change in the structural properties of the material of the photosensitive layer but will not ablate the material of the photosensitive layer.

Exposure parameters (e.g., parameters such as exposure time, exposure energy, and exposure wavelength) depend on the type of photoresist material and the thickness of the photosensitive layer. For Su-8 layers between 1.5-100 microns, it may be that the exposure time is between 3 and 18 seconds. For Su-8 layers between 1.5-100 microns, it may be that the exposure energy is between 70-540 mJ/cm². For SU-8, electromagnetic radiation in the ultraviolet range is appropriate. (e.g., a wavelength between 100 - 400 nm).

Forming the channels may comprise soft-baking the photosensitive layer (e.g., heating of the photosensitive layer) before exposure using electromagnetic radiation. The soft-baking may involve multiple rounds of heating. For example, there may be a first period of heating at a first temperature, followed by a second period of heating at a second temperature different from the first temperature.

Electromagnetic radiation is directed on at least part of the photosensitive layer - e.g., at least part of the photosensitive layer is irradiated with electromagnetic radiation.

Following exposure with electromagnetic radiation, the photosensitive layer may be baked again.

Forming the channels may involve washing the photosensitive layer using a photodeveloper solution.

The one or more MEMS actuators may be configured to extract and/or deliver fluid via the one or more channels. It may be that the one or more MEMS actuators is configured for use as a pump. It may be that each of the MEMS actuators is configured for use as a pump.

Throughout the specification, where a limitation is specified in relation to "one or more" or "at least one" of a feature, where there are a plurality of the same feature, this also encompasses that limitation applying to each of, or some of, the plurality of features.

For example, it will be understood that any reference to at least one of the one or more MEMS actuators having a feature includes the possibility that the, or each, or some of the MEMS actuators have that feature - e.g., that every MEMS actuator has that feature. Likewise, it will be understood that any reference to at least one of the one or more channels having a feature includes the possibility that the or each channel has that feature - e.g., that every channel has that feature.

It may be that the fluidic device is configured to deliver fluid for combination with another fluid (e.g., the fluid is delivered to a container for accommodating another fluid).

It may be that the fluidic device is configured to deliver liquid for combination with another liquid. It may be that the fluidic device is configured to deliver liquid for combination with a gas.

It may be that the fluidic device is configured for delivery of small volumes of fluid. For example, it may be that the fluidic device is configured for ejection of droplets having a radius of less than 50 µm. It may be that the fluidic device is configured for ejection of droplets having a radius of less than 30 µm. It may be that the fluidic device is configured for ejection of droplets having a radius of less than 20 µm. It may be that the fluidic device is configured for ejection of droplets having a radius of less than 10 µm. It may be that the fluidic device is configured for ejection of droplets having a radius of less than 3 µm.

It may be that the fluidic device is configured for ejection of droplets having a radius of greater than 1 µm. It may be that the fluidic device is configured for ejection of droplets having a radius of greater than 5 µm. It may be that the fluidic device is configured for ejection of droplets having a radius of greater than 10 µm. It may be that the fluidic device is configured for ejection of droplets having a radius of greater than 20 µm.

For example, it may be that the fluidic device is configured for ejection of droplets having a radius of greater than 1 µm and less than 30 µm. It may be that the fluidic device is configured for ejection of droplets having a radius of greater than 1 µm and less than 3 µm. It may be that the fluidic device is configured for ejection of droplets having a radius of greater than 20 µm and less than 30 µm.

It may be that each MEMS actuator comprises a single corresponding channel therethrough. It may be that at least one (e.g., each) MEMS actuator comprises multiple channels therethrough. It may be that at least one (e.g., each) MEMS actuator comprises less than 10 channels therethrough.

It may be that the photosensitive layer defines at least a portion of the one or more channels (e.g., each of the channels).

It may be that the one or more MEMS actuators comprises one or more materials processable at a temperature below 450°C.

It may be that the or each MEMS actuator comprises a moveable piezoelectric diaphragm, wherein the moveable piezoelectric diaphragm comprises a piezoelectric body, a first electrode and a second electrode. It may be that the piezoelectric body comprises one or more piezoelectric materials processable at a temperature below 450°C. Examples of piezoelectric materials that are processable at temperatures below 450°C include aluminium nitride (AIN), zinc oxide (ZnO), and/or scandium aluminium nitride (ScAIN).

The fluidic device is configured to move fluid through the one or more channels using the one or more MEMS actuators. Typically, the fluidic device is configured to move fluid through the one or more channels using movement of at least part of the one or more MEMS actuators. For example, it may be that the or each MEMS actuator comprises a moveable piezoelectric diaphragm, wherein movement of at least one of the moveable piezoelectric diaphragms causes movement of the fluid through at least one of the one or more channels. It may be that each MEMS actuator comprises a moveable piezoelectric diaphragm configured to move fluid through at least one respective channel.

Some electronics (e.g., CMOS components) can be damaged at temperatures greater than 450°C. By using piezoelectric materials that are processable at a temperature below 450°C, MEMS and electronic components can be integrated whilst avoiding degradation of the electronics, thereby improving the operation and efficiency of the device.

It may be that the moveable piezoelectric diaphragm is deposited between the photosensitive layer and the substrate. It may be that etching of the substrate and/or other MEMS components is carried out prior to deposition of the photosensitive layer. It may be that the photosensitive layer is deposited using spin coating.

At least one of the one or more MEMS actuators may comprise a PMUT.

The or each MEMS actuator, including the photosensitive layer, is deposited on (e.g., formed on) the substrate. The MEMS actuators may be deposited using one or more PVD methods. Importantly, the or each MEMS actuator is formed on the substrate rather than being formed separately and later bonded. It may be that the photosensitive layer is deposited after another component of at least one MEMS actuator is deposited (e.g., after one or more electrodes and/or piezoelectric body is deposited).

The substrate may comprise a silicon wafer. The substrate may be a semiconductor substrate.

It may be that the fluidic device is a droplet ejector. It may be that fluidic device is for ejecting liquid. It may be that the fluidic device is a droplet ejector for ejecting liquid.

In accordance with an aspect of the present invention, there is provided a fluidic device comprising:
one or more MEMS actuators, deposited in one or more steps, on a substrate,
the one or more MEMS actuators comprising a photosensitive layer;
one or more channels through at least a portion of the photosensitive layer;
wherein the photosensitive layer was photosensitive at least immediately before the one or more channels were formed; and
wherein the fluidic device is configured to move fluid through the one or more channels using the one or more MEMS actuators.

It will be understood that the photosensitive layer may no longer be photosensitive after the or each channel has been formed (e.g., because the structural properties of the material have already been irreversibly changed by the incident electromagnetic radiation).

It may be that at least one of the one or more of the channels have a constant width.

It may be that at least one of the one or more channels comprises a first part having a first channel width and a second part having a second channel width different from the first channel width, wherein the first part is closer to a first plane parallel to and coincident with a surface of the substrate than the second part.

It may be that the or each channel comprises a first part having a first channel width and a second part having a second channel width different from the first channel width. It may be that each channel of the device has the same first channel width as each other channel of the device. It may be that each channel of the device has the same second channel width as each other channel of the device.

Advantageously, by forming at least part of the one or more channels by directing electromagnetic radiation onto the photosensitive layer it is possible to more easily provide channels having varying widths compared to conventional etching processes. Compared to physical etching methods, the use of electromagnetic radiation provides more control over the shape of the channels. This is partly because it is challenging to control the remove rate of reactive etched material when using physical etching methods.

It may be that the shape of the at least one channel (e.g., first and second widths, and the transition between those widths) is selected based on the fluidic properties of the fluid (e.g., viscosity, surface tension, density) being delivered and/or received through the channel. It may be that the shape of the at least one channel is selected based on the desired flow of the fluid (e.g., rapid ejection, slow pumping, fluid extraction from a target body). It may be that the shape of the at least one channel is selected based on the conditions at the fluid destination. For example, in embodiments configured to deliver fluid for combination with a second fluid, it may be that the shape of the at least one channel is selected based on the properties of the second fluid (e.g., viscosity, surface tension, density, pressure). It may be that the shape of the at least one channel is selected based on the type of MEMS actuator (e.g., a piezoelectric actuator and/or an actuator for applying a DC pressure).

It may be that the first channel width is larger than the second channel width.

In particular, it may be that the channel is a convergent tapered channel, having a larger diameter section closer to the first plane (as defined above) compared to a smaller diameter section further from the first plane. Typically, the convergent tapered channel is defined by at least one channel wall having a first point at the first part of the channel and a second point at the second part of the channel, wherein the channel wall is angled relative to the first plane at least between the first point and the second point, wherein the angle of the channel wall relative to the first plane is constant between the first point and the second point.

The inventors have realised that the energy required to eject a droplet can be reduced by providing a tapered channel - e.g., a convergent tapered channel. Generally, smaller droplets require higher ejection forces. By using a tapered channel the inventors have realised that the forces required to eject a droplet can be reduced, thereby also reducing the required energy. The reduced energy consumption of the fluidic device is associated with a range of advantages. In particular, it may be possible to supply a lower voltage to the actuator for moving fluid through the at least one channel. By providing a tapered shape, voltage reductions of up to 30% (compared to straight channels) are possible. This means it is possible to provide devices with more overall functionality. For example, working at lower voltages also makes it more straightforward to provide integrated CMOS circuitry - which facilitates increased control/sensing functionality. Further, lower voltage gradients (e.g., potential difference over piezoelectric membranes) within the device, along with lower material strains of actuator materials facilitates improved device longevity. Further, the reduced energy requirements mean that the overall energy input to the system can be less - this in turn limits heat generation within the fluidic device (e.g., thermal ramp, particularly for actuators operating at high frequencies, is reduced).

Particularly for fluidic devices comprising multiple MEMS actuators, this tapered channel shape is effective at reducing cross-talk phenomena. That is, the reduction of the force required to control a MEMS actuator reduces the local pressure change and therefore reduces the effect of that pressure on surrounding actuators.

Surprisingly, the inventors have further realised that providing channels shaped in this way reduces the ingestion of air, or other fluid surrounding the device, following the ejection of the fluid through the channel. This air ingestion (gulping) is undesirable as it reduces device efficiency. By providing tapered channels the air ingestion is reduced, thereby facilitating more efficient droplet ejection.

Typically, as fluid is ejected from a droplet ejector having a channel, the fluid extends in the direction parallel to the channel length as it is ejected (i.e., a fluid stalk/column is formed). A portion of this fluid column narrows until a droplet eventually breaks off. The narrowest point of this column about which the droplet is formed and separates is called the stagnation point. Providing this tapered channel shape (e.g., a convergent tapered channel) causes increased narrowing of the fluid stalk at the stagnation point (compared to orthogonal channels with the same outlet diameter). The convergent tapered shape causes an increased velocity gradient at the stagnation point, thereby causing more rapid droplet separation and improved control of droplet formation. This has advantages in many applications involving droplet ejection - e.g., in printing applications where higher print quality is facilitated.

Further, the inventors have realised that convergent tapered nozzles facilitate improved fluid ejection of fluids which can be challenging to eject - e.g., fluids with relatively low viscosity and high surface tension (such as water, for example). This is because the tapered nozzle facilitates improved control of the fluid meniscus.

It may be that the fluidic device is a fluidic device for use with (e.g., for ejecting) a low viscosity fluid, wherein the low viscosity fluid has a viscosity of 4 cP (4 mPa s) or less.

It may be that the fluidic device is a fluidic device for use with (e.g., for ejecting) a fluid having a high surface tension, wherein the fluid has a surface tension of at least 50 mN/m. It will be understood that the surface tension may be measured using the pendant drop method and using a tensiometer.

It will be understood that viscosity and surface tension are temperature dependent. The values provided above are the fluid properties at a temperature of 20°C.

Using conventional etching methods, it is difficult to provide a channel having a larger diameter section closer to the first plane compared to a smaller diameter section further from the substrate. This is because the layers being etched are only accessible from one side during typical manufacturing processes (e.g., the side closest to the MEMS components). Therefore, physical etching typically results in a divergent shape (e.g., larger diameter further from the first plane).

Using electromagnetic radiation to shape the channels allows for significant control over the channel shape - e.g., the amount of tapering/angle of the walls of the channel. Channel walls angled relative to the vertical (i.e., angled relative to the direction perpendicular to the surface of the substrate) even slightly can be advantageous. For example, at least one of the channel walls may be angled by less than 10 degrees relative to the vertical. It may be that at least one of the channel walls is angled by less than 5 degrees relative to the vertical. It may be that at least one of the channel walls is angled by less than 3 degrees relative to the vertical. It may be that at least one of the channel walls is angled by less than 1 degree relative to the vertical.

At least one of the channel walls may be angled by greater than 1 degree relative to the vertical. At least one of the channel walls may be angled by greater than 3 degrees relative to the vertical.

It may be that the fluidic device comprises one or more cavities formed in the substrate, wherein the one or more MEMS actuators define at least part of a wall of at least one of the cavities. It may be that the first part of the at least one channel is closer to an opening between the at least one channel and a respective cavity (compared to the second part of the channel).

It may be that the fluidic device is configured to eject fluid accommodated within the at least one cavity via a respective channel (e.g., using motion of the MEMS actuator). It may be that the fluidic device is configured to receive fluid to at least one cavity (e.g., using motion of the MEMS actuator). It may be that the fluid is received via a convergent tapered channel.

It may be that each MEMS actuator is associated with a respective single cavity.

It may be that the channel is defined by at least one channel wall having a first point at the first part of the channel and a second point at the second part of the channel, wherein the channel wall is angled relative to the first plane at least between the first point and the second point, wherein the angle of the channel wall relative to the first plane is constant between the first point and the second point.

It may be that the first part of the at least one channel defines a first edge of the channel closest to the first plane (e.g., a first outlet), and wherein the second part of the at least one channel defines a second edge of the channel furthest from the first plane (e.g., a second outlet). It may be that the first point is associated with (is coincident with) the first edge and the second point is associated with (is coincident with) the second edge. It may be that the width of the channel is largest at the first outlet. It may be that the width of the channel is smallest at the second outlet.

It may be that the channel is defined by a single wall.

The inventors have realised that a tapered channel which is shaped to have the narrowest portion defining the edge of the channel furthest from the first plane and the widest portion closest to the first plane (e.g., coincident with the first plane), wherein a wall of the channel has a constant angle relative to the first plane between the widest and narrowest portion, is particularly energy efficient.

It may be that the fluidic device comprises control circuitry integrally formed within the substrate, the control circuitry being electrically coupled to the one or more MEMS actuators. It may be that the control circuitry is distributed - e.g., the control circuitry may comprise a first circuit located within a first region, and a second circuit located within a second region different from the first region. It may be that at least part of the control circuitry is arranged externally to the substrate (an external portion of the control circuitry may be in electrical connection to at least one MEMS actuator via conductive connections).

By providing a fluidic device having integrated control circuitry electrically coupled to the MEMS actuator deposited on the substrate, it is possible to provide a highly integrated device having a small-form factor. This arrangement avoids or limits the need for separate electronics (not integrated with the control circuitry). Accordingly, it is made possible to provide fluidic devices which are portable whilst also having the high functionality (e.g., control/sensing) enabled by the combination of a MEMS element and control circuitry.

Since each MEMS element is formed on the substrate having the integrally formed control circuitry, the device is also relatively straightforward to manufacture (e.g., compared to other integrated devices where the MEMS components and control circuitry are manufactured separately before being bonded together).

It may be that the control circuity comprises CMOS control circuitry.

The CMOS control circuitry may be formed using conventional CMOS fabrication techniques (e.g. ion implantation, chemical vapour deposition (CVD), physical vapour deposition (PVD), etching, chemical-mechanical planarization (CMP) and/or electroplating).

It may be that the minimum cross-sectional width of at least one of the channels is 1 x 10⁻⁶ m (1 micron). It may be that the minimum cross-sectional width of at least one of the channels is 3 × 10⁻⁶ m (3 microns). It may be that the minimum cross-sectional width of at least one of the channels is 5 × 10⁻⁶ m (5 microns). It may be that the minimum cross-sectional width of at least one of the channels is 7 × 10⁻⁶ m (7 microns). It may be that the minimum cross-sectional width of at least one of the channels is 10 × 10⁻⁶ m (10 microns). It may be that the minimum cross-sectional width of at least one of the channels is 15 × 10⁻⁶ m (15 microns).

It may be that the maximum cross-sectional width of at least one of the channels is 20 × 10⁻⁶ m (20 microns). It may be that the maximum cross-sectional width of at least one of the channels is 30 × 10⁻⁶ m (30 microns). It may be that the maximum cross-sectional width of at least one of the channels is 50 × 10⁻⁶ m (50 microns). It may be that the maximum cross-sectional width of at least one of the channels is 100 x 10⁻⁶ m (100 microns).

It may be that the maximum cross-sectional area of at least one of the channels is 3 × 10⁻¹⁰ m² (300 square micrometres). It may be that the maximum cross-sectional area of at least one of the channels is 5 × 10⁻¹⁰ m² (500 square micrometres). It may be that the maximum cross-sectional area of at least one of the channels is 1 × 10⁻⁹ m² (1000 square micrometres). It may be that the maximum cross-sectional area of at least one of the channels is 5 × 10⁻⁹ m² (5000 square micrometres).

It may be that the minimum cross-sectional area of at least one of the channels is 5 × 10⁻¹³ m² (0.5 square micrometres). It may be that the minimum cross-sectional area of at least one of the channels is 1 × 10⁻¹² m² (1 square micrometres). It may be that the minimum cross-sectional area of at least one of the channels is 1 × 10⁻¹¹ m² (10 square micrometres). It may be that the minimum cross-sectional area of at least one of the channels is 5 × 10⁻¹¹ m² (50 square micrometres). It may be that the minimum cross-sectional area of at least one of the channels is 1 × 10⁻¹⁰ m² (100 square micrometres).

It may be that the fluidic device comprises at least one cavity formed in the substrate, wherein at least one of the one or more MEMS actuators defines at least part of a wall of the cavity, and optionally wherein the cavity contains a fluid.

The fluid may be extracellular fluid (e.g., interstitial skin fluid). The liquid may be a pharmaceutical fluid (e.g., medication/medicinal drugs such as antibiotics, insulin or vaccines). The fluid may comprise cannabinoids (e.g., cannabidiol). The fluid may comprise small molecule ingredients. The fluid may be ink (e.g., for printing).

It may be that at least one of the one or more channels is in fluidic communication with the cavity. It may be that the fluidic device further comprises a transition surface between an inner surface of the channel and the wall of the cavity, the transition surface defining an opening between the channel and the cavity, wherein the shape of the transition surface is selected based on one or more desired flow properties of fluid moving between the cavity and the channel.

It may be the first edge of the channel closest to the first plane (e.g., the first outlet) defines the opening.

According to an aspect of the inventions there is provided a fluidic device comprising:
a MEMS actuator, deposited in one or more steps, on a substrate,
a channel through the MEMS actuator;
wherein the MEMS actuator is configured to move fluid through the channel
a cavity in the substrate, wherein the MEMS actuator defines, at least in part, a wall of the cavity;
wherein the channel is in fluidic communication with the cavity; and
a transition surface between an inner surface of the channel and the wall of the cavity, at least part of the transition surface defining an opening between the channel and the cavity, wherein the shape of the transition surface is selected based on one or more desired flow properties of fluid moving between the cavity and the channel.

Typically, the transition surface extends between the inner surface of the channel and the wall of the cavity around the circumference of the opening (e.g., the full circumference of the opening). It may be that the tangent to the averaged path at each respective point along the transition surface between a first point on the channel surface adjacent to the transition surface and a second point, which is adjacent to the transition surface, on the wall changes (e.g., changes gradually) from being aligned along a first direction to being aligned along a second direction. It may be that a first plane tangential to the inner surface at the first point is coincident with a vector aligned along the first direction. It may be that a second plane tangential to the wall at the second point is coincident with a vector aligned along the second direction.

It may be that the transition surface is curved. It may that the transition surface defines a rounded corner between the inner surface and the wall.

The inventors have realised that by providing a fluidic device having a transition surface as defined herein that one or more properties of the fluid flow between the cavity and channel can be controlled. For example, this shaping of the boundary between the fluid and the device can be used to reduce flow resistance, meaning that fluid ejection from the cavity via the channel can be provided using less energy/force. Other desired flow properties include specific flow rates and ejection volumes.

It may be that the MEMS actuator is one of a plurality of MEMS actuators. It may be that the channel is one of a plurality of channels. It may be that the cavity is one of a plurality of cavities. It may be that each MEMS actuator has a respective channel therethrough, and a respective cavity. It may be that each MEMS actuator defines, at least in part, a wall of a respective cavity.

According to an aspect of the invention there is provided a method for fabricating a fluidic device, the method comprising:
providing a MEMS actuator, deposited in one or more steps, on a substrate;
forming a channel through the MEMS actuator;
wherein the fluidic device is configured to move fluid through the channel using the MEMS actuator;
forming a cavity in the substrate, wherein the MEMS actuator defines, at least in part, a wall of the cavity;
wherein the channel is in fluidic communication with the cavity,
forming a transition surface between an inner surface of the channel and the wall of the cavity, at least part of the transition surface defining an opening between the channel and the cavity, wherein the shape of the transition surface is selected based on one or more desired flow properties of fluid moving between the cavity and the channel.

It may be that the MEMS actuator comprises a photosensitive layer, wherein the step of forming the transition surface comprises directing electromagnetic radiation on at least part of the photosensitive layer.

According to an aspect of the invention there is provided a method for fabricating a fluidic device, the method comprising:
providing one or more fluid ejectors, deposited in one or more steps, on a substrate, the one or more fluid ejectors comprising a photosensitive layer; and
forming one or more channels through at least a portion of the photosensitive layer,
wherein the fluidic device is configured to move fluid through the one or more channels using the one or more fluid ejectors,
wherein the step of forming the one or more channels comprises directing electromagnetic radiation on at least part of the photosensitive layer.

It may be that at least one of the one or more channels comprises a first part having a first channel width and a second part having a second channel width different from the first channel width.

According to an aspect of the invention there is provided a fluidic device comprising:
one or more fluid ejectors;
a photosensitive layer;
one or more channels through at least a portion of the photosensitive layer;
wherein the photosensitive layer was photosensitive at least immediately before the one or more channels were formed, and
wherein the fluidic device is configured to move fluid through the one or more channels using the one or more fluid ejectors.

It may that at least one of the one or more channels comprises a first part having a first channel width and a second part having a second channel width different from the first channel width.

At least one of the one or more fluid ejectors may comprise (e.g. be) an actuator, such as a MEMS actuator. The one or more fluid ejectors may be deposited in one or more steps on a substrate. The one or more fluid ejectors may comprise a photosensitive layer.

According to an aspect of the invention there is provided a fluidic droplet ejection system comprising one or more fluidic devices as described herein. It may be that the fluidic droplet ejection system comprises an aerosoliser, an inkjet printer module, or a fluid mixing module.

According to an aspect of the invention there is provided a liquid suitable for any of the fluidic devices as described herein.

The present invention extends to any of the fluidic devices described hereinbefore, comprising the liquid.

It may be that the liquid has a viscosity of 4 cP (4 mPa s) or less.

It may be that the liquid has a surface tension of at least 50 mN/m.

According to another aspect of the invention there is provided computer program code or semiconductor fabrication instructions which, when executed by a processor or executed as semiconductor fabrication steps, create any of the devices or systems as aforesaid.

Although the embodiments described above (and below) with reference to the drawings may comprise computer-related methods or apparatus, the invention may also extend to program instructions, particularly program instructions on or in a carrier, adapted for carrying out the processes of the invention or for causing a computer to perform as the computer apparatus of the invention. Programs may be in the form of source code, object code, a code intermediate source, such as in partially compiled form, or any other form suitable for use in the implementation of the processes according to the invention. The carrier may be any entity or device capable of carrying the program instructions.

Thus, there is specifically provided in a further aspect of the invention a non-transitory computer readable medium encoding computer program code which, when executed on at least one processor of a computer, causes the computer (or any appropriate combination of computers, with appropriate distribution of the computer program code) to carry out any appropriate method as aforesaid.

For example, the carrier may comprise a storage medium, such as a magnetic recording medium, for example a solid state disk or hard disk, or flash memory, optical memory, and so on. Further, the carrier may be a transmissible carrier such as an electrical or optical signal which may be conveyed via electrical or optical cable or by radio or other means. When a program is embodied in a signal which may be conveyed directly by cable, the carrier may be constituted by such cable or other device or means.

Features, integers, characteristics, or groups described in conjunction with a particular aspect are to be understood to be applicable to any other aspect described herein unless incompatible therewith. It will be understood that all of the features and/or all of the steps of any aspect disclosed hereinabove may be combined in any combination, except combinations where at least some of such features and/or steps are mutually exclusive.

### Description of the Drawings

An example embodiment of the present invention will now be illustrated with reference to the following Figures in which:
Figure 1 is a flowchart illustrating a method of manufacturing a fluidic device according to an embodiment of the invention;
Figures 2A-2C are schematic representations of a method of manufacturing a fluidic device according to an embodiment of the invention;
Figures 3A-3C are schematic representations of a method of manufacturing a fluidic device according to an embodiment of the invention;
Figure 4 is a schematic representation of a fluidic device according to an embodiment of the invention;
Figure 5 is a schematic representation of a fluidic device according to an embodiment of the invention; and
Figure 6 is a flowchart illustrating a method of manufacturing a fluidic device according to an embodiment of the invention.

### Detailed Description of an Example Embodiment

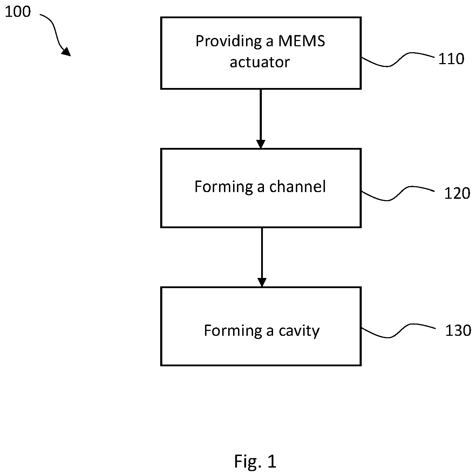

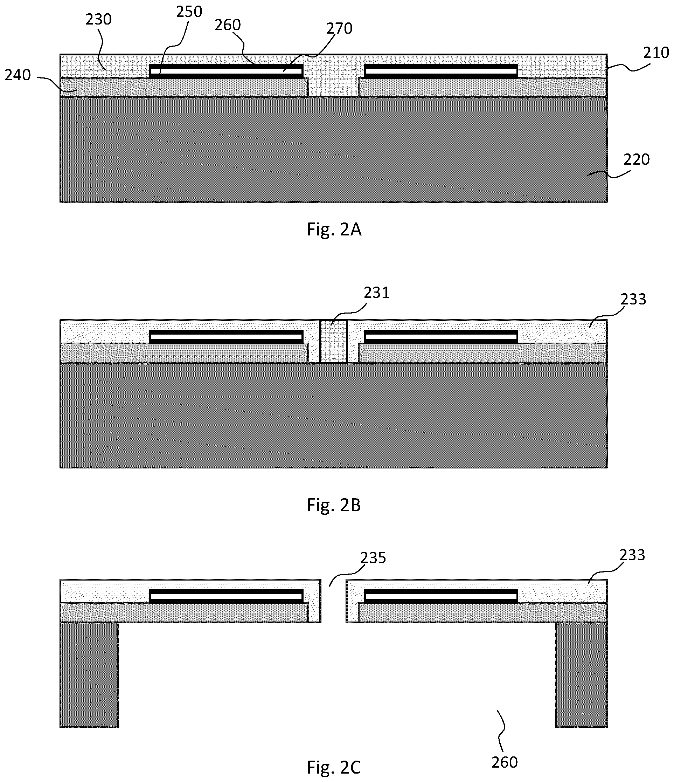

Figure 1 is a flowchart illustrating a method 100 of manufacturing a fluidic device according to an embodiment of the invention. Figures 2A-2C are schematic representations of this method at different stages of manufacture.

The method 100 comprises a step 110 of depositing a MEMS actuator 210 on a substrate 220. The MEMS actuator 210 comprises a photosensitive layer 230. The method 100 further comprises a step 120 of forming a channel 235 through the photosensitive layer 230 by directing electromagnetic radiation onto part of the photosensitive layer 230. The method 100 further comprises a step 130 of forming a cavity 260 in the substrate 220.

As shown in Figures 2A-2C, the MEMS actuator 210 comprises the photosensitive layer 230, a CMOS oxide layer 240, a first electrode 250, a second electrode 260 and a piezoelectric body 270.

Typically, step 110 involves using thin film deposition technique to deposit the electrodes and piezoelectric body. The piezoelectric body in this embodiment comprises ScAIN, which may be deposited at a temperature below 450°C by physical vapour deposition (including low-temperature sputtering). The electrodes are formed of, for example, titanium, platinum, aluminium, tungsten or alloys thereof. Any desired etching of these deposited layers is performed before the photosensitive layer is deposited using a spin coating technique. In this embodiment SU-8 is used as the photosensitive layer.

The SU-8 layer is baked by heating the layer to around 65-95°C for a period of time (the time depends on the thickness of the layer - and is typically a few minutes for a SU-8 layer of between 1-100 microns). In this embodiment, a 5 micron layer of SU-8 is pre-baked for 1 minute at 65 °C. The SU-8 layer is then soft-baked for 2 minutes at a temperature of 95 °C. The layer is then allowed to return to room temperature.

Step 120 involves exposing the SU-8 layer with electromagnetic radiation. The surface of the SU-8 furthest from the substrate 220 is exposed. For SU-8, exposure of electromagnetic radiation in the ultraviolet range is appropriate (e.g., 100 - 400 nm). Typically, a wavelength of around 360 - 400 nm is used. An exposure energy of between 80-120 mJ/cm² (e.g., 100 mJ/cm²) is used. In this example, an exposure time of around 4 seconds is used. A photomask is used to control which parts of the SU-8 layer are exposed. As shown by the shading in Figure 2B, the part 233 of the SU-8 exposed to UV light changes relative to the part 231 which is not exposed. The UV light causes cross-linking of the molecular chains of the SU-8 (i.e., polymerisation).

Following exposure, the SU-8 layer is baked again. Once for 1 minute at 65 °C, and then for 1 minute at 95 °C.

The part 231 of the SU-8 layer which was not exposed to UV radiation is washed off using an SU-8 developer (e.g., for around 1 minute). The SU-8 layer may be soaked in an IPA bath for a further 30 seconds. These removal steps are repeated if necessary to leave a channel 235 - as shown at Figure 2C. The walls of the channel 235 are defined by part of the cross-linked SU-8 layer 233. The cavity 260 is formed using a DRIE etch procedure from the backside (i.e., the opposite side to which the actuator is deposited) of the substrate 220.

In use, the MEMS actuator 210 is configured to move fluid through the channel 235 by deforming into the cavity 260.

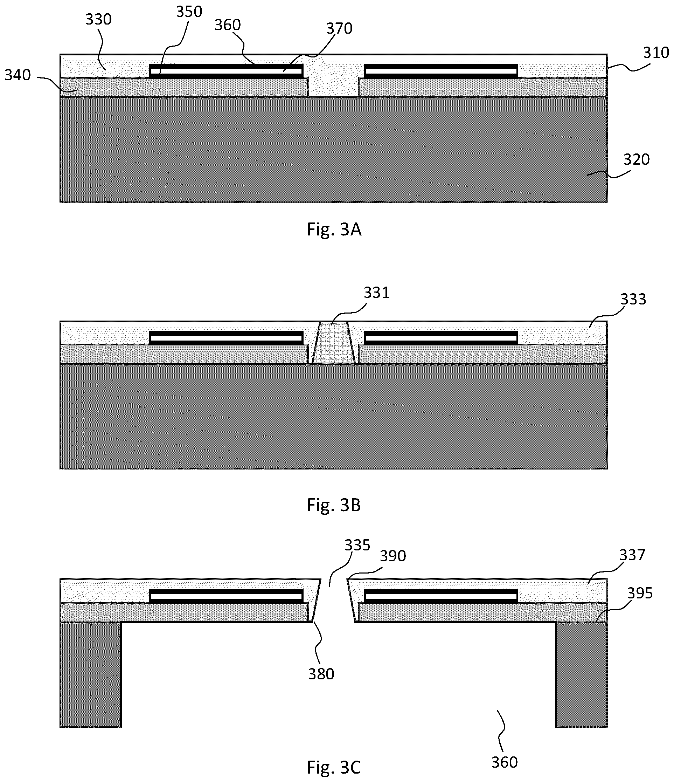

Figures 3A-3C provide schematic representations of a method at different stages of manufacture according to another embodiment of the invention. The MEMS actuator 310 comprises a photosensitive layer 330, an additional layer 340, a first electrode 350, a second electrode 360 and a piezoelectric body 370. Figure 3A shows the step of providing a MEMS actuator 310 on a substrate 320.

In this example, the photosensitive layer is a positive photoresist material. Figure 3B represents the step of exposing the photosensitive layer 330 to electromagnetic radiation. In this example the beam of electromagnetic radiation is focussed to irradiate the part 331 of the photosensitive layer 330. The surface of the SU-8 furthest from the substrate 320 is exposed. The exposed part 331 of the photosensitive layer, shown in Figure 3B, is removable using a photodeveloper solution.

As shown in Figure 3C, the unexposed part 337 is left behind to define a convergent tapered channel 335. The convergent tapered channel 335 has a first part 380 and a second part 390. The first part 380 has a width greater than the second part 390. The first part 380 of the convergent tapered channel 335 defines a first edge of the channel closest to a surface 395 of the substrate 320, and the second part 390 defines a second edge of the channel furthest from the surface 395 of the substrate 320. The wall of the channel is angled relative to the surface 395 of the substrate 320. The angle of the wall is constant between the first edge and the second edge. In other words, a wall of the convergent tapered channel 335 is substantially straight from the first part 380 to the second part 390. A cavity 360 is formed by etching.

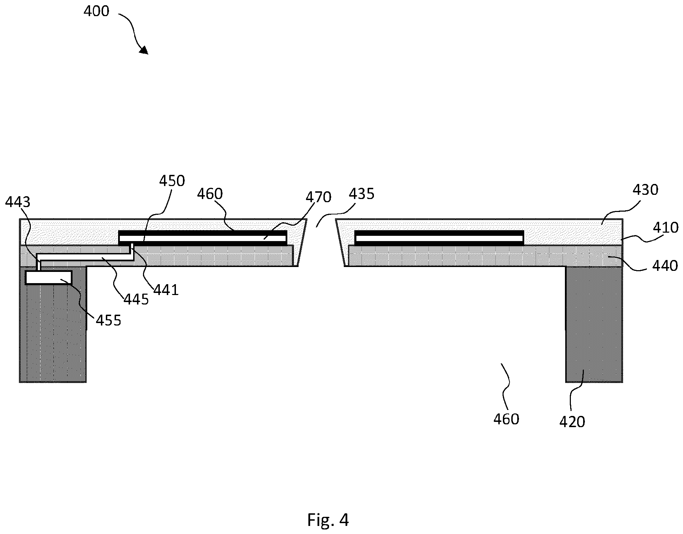

Figure 4 is a schematic representation of a fluidic device 400 according to an embodiment of the invention. In this embodiment, the fluidic device 400 is a droplet ejector 400 for a print module. The ejector 400 includes a MEMS actuator 410 formed on a substrate 420. The MEMS actuator 410 has a photosensitive layer 430 which defines a tapered channel 435. As shown in Figure 4, the MEMS actuator 410 also includes an additional layer 440, a first electrode 450, a second electrode 460 and a piezoelectric body 470. The MEMS actuator 410 is electrically connected to control circuitry 455 in the form of CMOS circuitry 455 via metallisation layers 445 and conductive connections 441,443. The CMOS circuitry 455 comprises a plurality of transistors integrally provided with the substrate.

The transistors may be formed by standard CMOS processing methodologies including ion implantation on a p-type or n-type substrate. The metallisation layers 445 and conductive connections 441,443, can also formed by standard processes such as ion implantation chemical vapour deposition, physical vapour deposition, etching, chemical-mechanical planarization and/or electroplating.

In use, the CMOS control circuitry 455 is configured to control movement of the MEMS actuator 410. In particular, the CMOS circuitry 455 generates a drive signal which is conducted through the metallisation layers 445 to at least one of the electrodes 450, 460 to cause the actuator 410 to deform into the cavity 460. The cavity 460 is configured to accommodate ink (not shown). The movement of the actuator 410 causes a droplet of ink to be forced through the channel 435. Advantageously, the tapered shape of the channel 425 means that less energy is required to cause droplet ejection.

Although Figure 4 has described a droplet ejector 400 for a print module, to eject droplets of ink, it will be understood that similar devices can be used to eject droplets of liquids other than ink.

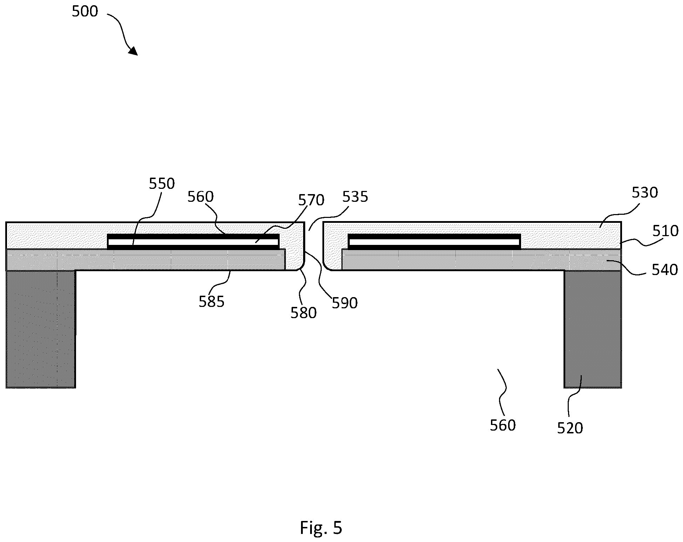

Figure 5 is a schematic representation of a fluidic device 500 according to another embodiment of the invention. This fluidic device is similar to the droplet ejector 400 shown in Figure 5. In particular, the fluidic device 500 comprises a MEMS actuator 510 formed on a substrate 520. The MEMS actuator 510 has a photosensitive layer 530, an additional layer 540, a first electrode 550, a second electrode 560 and a piezoelectric body 570. A cavity 560 is defined in part by the MEMS actuator 510 and in part by the substrate 520. One difference between the fluidic device 500 and droplet ejector 400, is that the fluidic device 500 has curved corners 580 at the base of the fluidic channel - i.e., a transition surface 580 between an inner surface of the channel 590 and the wall 585 of the cavity defined by the additional layer 540. Advantageously, this also reduces the energy required to eject fluid from within the cavity 560. Further, undesired ingestion of the surrounding fluid (e.g., air) is avoided - i.e., gulping is limited.

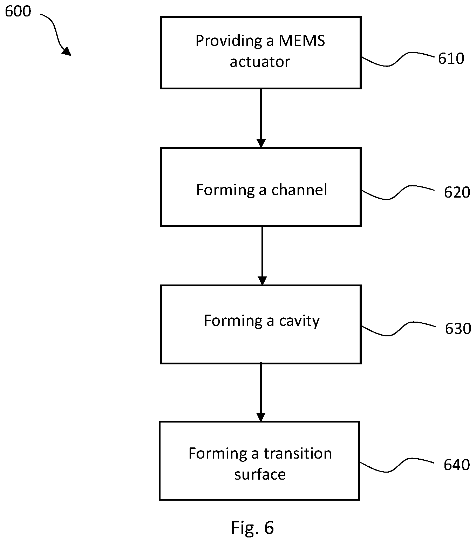

Figure 6 is a flowchart illustrating a method 600 of manufacturing a fluidic device according to an embodiment of the invention.

The method involves a step 610 of depositing a MEMS actuator on a substrate. This step includes spinning on a photosensitive layer. In this embodiment the MEMS actuator includes a positive photoresist layer. The method involves a step 620 of forming a channel through the photoresist layer by irradiating part of the photosensitive layer with electromagnetic radiation. The part of the channel exposed to the electromagnetic radiation can be removed following exposure by washing with a photodeveloper solution. At step 630, a cavity is etched from the backside of the substrate. Step 640 involves shaping part of the channel to provide a transition surface between an inner surface of the channel and a wall of the cavity. The shape of the transition surface is controlled using steering and focussing of the electromagnetic radiation.

In summary, there is provided a method (100) for fabricating a fluidic device. The method comprises providing one or more MEMS actuators (210), deposited in one or more steps, on a substrate (220). The one or more MEMS actuators (210) comprise a photosensitive layer (230). The method further comprises forming one or more channels (235) through at least a portion of the photosensitive layer (230). The fluidic device is configured to move fluid through the one or more channels (235) using the one or more MEMS actuators (210). The step of forming the one or more channels (235) comprises directing electromagnetic radiation on at least part of the photosensitive layer (230).

Throughout the description and claims of this specification, the words "comprise" and "contain" and variations of them mean "including but not limited to", and they are not intended to and do not exclude other components, integers, or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, or groups described in conjunction with a particular aspect, embodiment, or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract and drawings), or to any novel one, or any novel combination, of the steps of any method or process so disclosed.

## Claims

1. A method for fabricating a fluidic device, the method comprising:
providing one or more MEMS actuators, deposited in one or more steps, on a substrate, the one or more MEMS actuators comprising a photosensitive layer; and
forming one or more channels through at least a portion of the photosensitive layer,
wherein the fluidic device is configured to move fluid through the one or more channels using the one or more MEMS actuators, and
wherein the step of forming the one or more channels comprises directing electromagnetic radiation on at least part of the photosensitive layer.

2. A fluidic device comprising:
one or more MEMS actuators, deposited in one or more steps, on a substrate,
the one or more MEMS actuators comprising a photosensitive layer;
one or more channels through at least a portion of the photosensitive layer;
wherein the photosensitive layer was photosensitive at least immediately before the one or more channels were formed; and
wherein the fluidic device is configured to move fluid through the one or more channels using the one or more MEMS actuators.

3. The method according to claim 1 or the fluidic device according to claim 2, wherein at least one of the one or more channels comprises a first part having a first channel width and a second part having a second channel width different from the first channel width, wherein the first part is closer to a first plane parallel to and coincident with a surface of the substrate than the second part.

4. The method or fluidic device according to claim 3, wherein the first channel width is larger than the second channel width.

5. The method or fluidic device according to claim 3 or claim 4 wherein the channel is defined by at least one channel wall having a first point at the first part of the channel and a second point at the second part of the channel, wherein the channel wall is angled relative to the first plane at least between the first point and the second point, wherein the angle of the channel wall relative to the first plane is constant between the first point and the second point.

6. The method or fluidic device according to any of claims 3-5 wherein the first part of the at least one channel defines a first edge of the channel closest to the first plane, and wherein the second part of the at least one channel defines a second edge of the channel furthest from the first plane.

7. The method or fluidic device according to any preceding claim wherein the fluidic device comprises control circuitry integrally formed within the substrate, the control circuitry being electrically coupled to the one or more MEMS actuators.

8. The method or fluidic device according to any preceding claim wherein the maximum cross-sectional width of at least one of the channels is 20 × 10⁻⁶ m (20 microns).

9. The method or fluidic device according to any preceding claim, wherein the fluidic device comprises at least one cavity formed in the substrate, wherein at least one of the one or more MEMS actuators defines at least part of a wall of the cavity, and optionally wherein the cavity contains a fluid.

10. The method or apparatus according to claim 9, wherein at least one of the one or more channels is in fluidic communication with the cavity, the fluidic device further comprising a transition surface between an inner surface of the channel and the wall of the cavity, the transition surface defining an opening between the channel and the cavity, wherein the shape of the transition surface is selected based on one or more desired flow properties of fluid moving between the cavity and the channel.

11. A fluidic device comprising:
a MEMS actuator, deposited in one or more steps, on a substrate,
a channel through the MEMS actuator;
wherein the MEMS actuator is configured to move fluid through the channel;
a cavity in the substrate, wherein the MEMS actuator defines, at least in part, a wall of the cavity;
wherein the channel is in fluidic communication with the cavity,
a transition surface between an inner surface of the channel and the wall of the cavity, at least part of the transition surface defining an opening between the channel and the cavity, wherein the shape of the transition surface is selected based on one or more desired flow properties of fluid moving between the cavity and the channel.

12. A method for fabricating a fluidic device, the method comprising:
providing a MEMS actuator, deposited in one or more steps, on a substrate;
forming a channel through the MEMS actuator;
wherein the fluidic device is configured to move fluid through the channel using the MEMS actuator;
forming a cavity in the substrate, wherein the MEMS actuator defines, at least in part, a wall of the cavity;
wherein the channel is in fluidic communication with the cavity; and
forming a transition surface between an inner surface of the channel and the wall of the cavity, at least part of the transition surface defining an opening between the channel and the cavity, wherein the shape of the transition surface is selected based on one or more desired flow properties of fluid moving between the cavity and the channel.

13. The method of claim 12, wherein the MEMS actuator comprises a photosensitive layer, wherein the step of forming the transition surface comprises directing electromagnetic radiation on at least part of the photosensitive layer.

14. A fluidic droplet ejection system comprising one or more fluidic devices according to any preceding claim, optionally wherein the fluidic droplet ejection system comprises an aerosoliser, an inkjet printer module, or a fluid mixing module.

15. A liquid suitable for any of the fluidic devices according to 1 or 3-13, or systems according to claim 14.
